# FASCICULE DE BREVET EUROPEEN

(11) **EP 3 720 261 B1**
(45) Date de publication et mention de la délivrance du brevet: **08.03.2023**
(21) Numéro de dépôt: 20165346.6
(22) Date de dépôt: 24.03.2020
(51) Int. Cl.: H05K 7/14

(54) **ARMOIRE INFORMATIQUE COMPRENANT DES DISPOSITIFS D'INTERCONNEXION DE COMMUTATEURS D'INTERCONNEXION ET D'ELEMENTS MONTABLES EN BÂTI**
IT-RACK, DAS VERBINDUNGSVORRICHTUNGEN MIT VERBINDUNGSSCHALTERN UND RACKMONTIERBAREN ELEMENTEN UMFASST
COMPUTER CABINET COMPRISING INTERCONNECTION DEVICES FOR INTERCONNECTION SWITCHES AND ELEMENTS TO BE MOUNTED IN A FRAME

(30) Priorité: 04.04.2019 FR 1903607
(43) Date de publication de la demande: 07.10.2020
(73) Titulaire: Bull SAS, 78340 Les Clayes-sous-Bois (FR)
(72) Inventeur: DEMANGE, Fabien, 78300 Poissy (FR)
(74) Mandataire: Cabinet Camus Lebkiri

(56) Documents cités:
- US-A1- 2017 257 970
- US-A1- 2018 295 737

## Description

### DOMAINE TECHNIQUE DE L'INVENTION

L'invention a pour objet un dispositif d'interconnexion de commutateurs d'interconnexion et de noeuds de calcul.

Le domaine technique de l'invention est celui des armoires informatiques configurées pour comprendre au moins des commutateurs d'interconnexion et des lames de calcul, c'est-à-dire des éléments d'interconnexion et de calcul ayant un format dit « rackable » ou encore montable en bâti.

Le domaine de l'invention est encore celui des calculateurs hautes performances.

Le domaine de l'invention est encore celui des centres de calculs et des centres de données.

### ARRIERE-PLAN TECHNOLOGIQUE DE L'INVENTION

Les armoires informatiques de l'état de la technique comprennent un bâti permettant d'accueillir des éléments montables en bâti, dont des commutateurs d'interconnexion. Dans le cas de calcul distribué, par exemple d'une application de l'armoire informatique au calcul haute performance (« HPC » selon la dénomination anglosaxonne « High Performance Computing »), les commutateurs d'interconnexion permettent d'interconnecter des noeuds de calcul compris dans des lames de calcul. Ces lames de calcul sont des éléments montables dans le bâti de l'armoire informatique. L'interconnexion de noeuds de calcul permet de distribuer les calculs sur plusieurs noeuds.

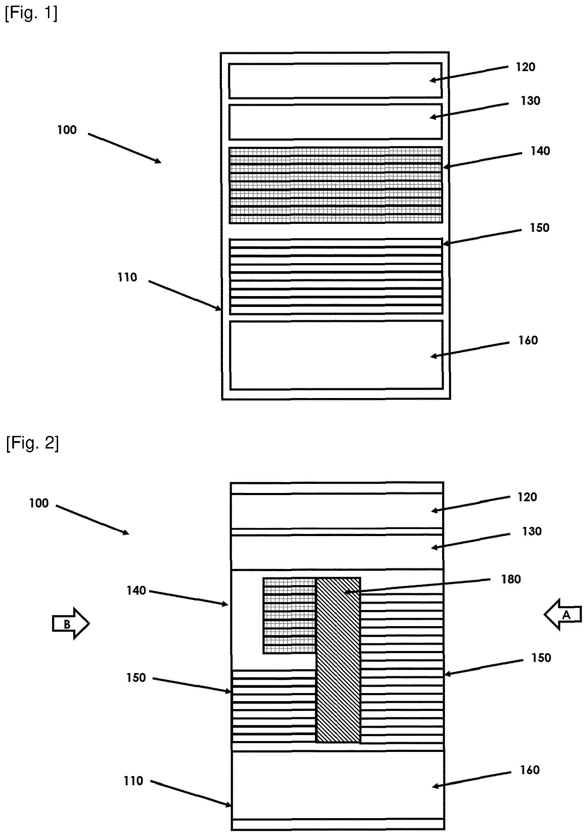

[Fig. 1] représente schématiquement une vue de face d'une armoire 100 de l'état de la technique.

Une armoire informatique 100 de l'état de la technique peut par exemple comprendre un bâti 110, une unité de distribution d'alimentation (« PDU » selon la dénomination anglo-saxonne « Power Distribution Unit ») 120, une unité d'alimentation (« PSU » selon la dénomination anglo-saxonne « Power Supply Unit ») 130, une pluralité de commutateurs d'interconnexion 140, une pluralité d'éléments montables en bâti 150 et une unité de refroidissement 160.

L'armoire informatique 100 représentée Figure 1 peut comprendre un bâti 110 respectant par exemple le standard 19 pouces. La largeur totale du bac à cartes du bâti des armoires informatiques 100 de l'état de la technique est de 482,6 mm, c'est-à-dire de 19 pouces, équerres de fixation comprises. Cette largeur est à l'origine du système de montage 19 pouces. Ainsi, la largeur des éléments accueillis par le bâti des armoires informatiques 100 de l'état de la technique respecte ce standard de 19 pouces. Par la suite, lorsqu'on mentionnera un élément montable en bâti « respectant le standard 19 pouces », on se référera à un élément ayant une largeur de façade permettant d'être monté dans le bâti dans une armoire informatique de 19 pouces, c'est-à-dire par exemple dont la largeur de façade est de 19 pouces ou dont la largeur de façade est inférieure à 19 pouces.

L'armoire informatique 100 comprend par exemple une pluralité de commutateurs d'interconnexion 140, chaque commutateur d'interconnexion de la pluralité de commutateurs d'interconnexion 140 pouvant par exemple avoir une hauteur de 1U. Dans une armoire informatique 100 de 19 pouces, l'espacement entre les éléments montables sur bâti, aussi dits « rackables », est habituellement un multiple d'une longueur nommée « unité de rack » (abréviation « U ») et qui mesure 1,75 pouces, soit 44,45 millimètres.

La hauteur d'une façade avant d'un équipement rackable n'est pas exactement un multiple entier de U car, pour permettre un montage facile d'équipements adjacents, un espace de 1/32 pouce, soit 0,031 pouce soit 0,79 mm, est laissé entre chaque façade. Ainsi, un élément ayant une façade de 1U aura une hauteur de 1,719 pouces, soit 43,66 millimètres. Par la suite, lorsqu'on mentionnera un élément montable en bâti « 1U », on se référera à un élément ayant une hauteur de façade permettant de respecter l'espacement d'une unité de rack (« 1U »), c'est-à-dire par exemple dont la hauteur de façade est de 1,719 pouces.

L'armoire informatique 100 comprend en outre une pluralité d'éléments montables en bâti 150, chaque élément montable en bâti de la pluralité d'éléments montables en bâti 150 pouvant par exemple avoir une hauteur de 1U.

Les éléments montables en bâti 150 peuvent par exemple être des lames de calcul. Ces lames de calcul peuvent par exemple respecter le standard 19 pouces. et être des lames 1U. Ces lames de calcul comprennent généralement plusieurs noeuds de calcul, par exemple trois. Un noeud de calcul de l'état de la technique comprend une pluralité de processeurs, par exemple deux processeurs, et une pluralité de barrettes mémoire, par exemple huit barrettes mémoire par processeur, c'est-à-dire dans le cas présent seize barrettes mémoire. Chaque processeur de chaque noeud de calcul permet d'exécuter des instructions de calcul.

Dans le cas du calcul haute performance, ces instructions de calcul sont généralement reçues par la lame de calcul 150 via un réseau d'interconnexion. Ce réseau d'interconnexion comprend des commutateurs d'interconnexion 140, étant des noeuds du réseau. Ainsi, les instructions de calcul peuvent être réparties entre les noeuds de calcul pour faire du calcul distribué.

Pour qu'une armoire 100 faisant partie d'un dispositif de calcul haute performance soit opérationnelle, il faut que les noeuds de calcul puissent recevoir des instructions de calcul et transmettre leurs résultats, et qu'ils puissent communiquer les uns avec les autres et donc il faut que :
- Les noeuds de calcul soient connectés à des commutateurs d'interconnexion ;
- Les commutateurs d'interconnexion soient connectés les uns avec les autres.

On appelle les commutateurs d'interconnexion de la pluralité de commutateurs d'interconnexion 140 connectés aux lames de calcul 150 des commutateurs d'interconnexion « L1 » (selon la dénomination anglo-saxonne « Level 1 » pour « Niveau 1 »). On peut faire référence à un commutateur d'interconnexion 140 par le terme « switch » selon la dénomination anglo-saxonne.

Les commutateurs d'interconnexion L1 sont connectés à des commutateurs d'interconnexion « L2 » (selon la dénomination anglo-saxonne « Level 2 » pour « Niveau 2 »). Ces commutateurs d'interconnexion L2 sont reliés à d'autres commutateurs d'interconnexion L2.

Le nombre de connexions varie en fonction d'une topologie réseau choisie. Parmi les topologies connues on cite au moins : fat tree bloquant, fat tree non bloquant, tore 3d, hypercube. Cette liste n'est pas limitative. Ainsi, dans certaines topologies, il peut y avoir deux niveaux voire trois niveaux de commutateurs d'interconnexion.

Quelle que soit la topologie il faut établir des connexions physiques intra-armoire entre au moins un commutateur d'interconnexion L1 140 d'une armoire 100 et au moins une lame de calcul 150 de la même armoire 100.

Au sein d'une armoire informatique, pour relier deux équipements, sont couramment utilisés des câbles optiques ou encore des câbles de cuivre. Pour les bus rapides, dont la vitesse est supérieure à 40 Gigabits par secondes, qui utilisent des liens à 10 Gigabits par secondes, à 25 Gigabits par secondes ou à 56 Gigabits par secondes modulés en PAM (selon la dénomination anglo-saxonne « Pulse Amplitude Modulation » pour « modulation de l'amplitude des impulsions »), le format très majoritairement utilisé est le format QSFP (selon la dénomination anglo-saxonne « Quad Small Form-Factor Pluggable »). Le QSFP est un émetteur-récepteur compact et connectable à chaud.

Ainsi, des câbles, de cuivre ou optiques, à connecteurs QSFP sont couramment utilisés pour relier les lames de calcul 150 d'une armoire informatique 100 aux commutateurs d'interconnexion L1 140.

Dans l'état de la technique, une armoire informatique 100 peut être livrée avec une topologie fixe « précablée », permettant une utilisation simple et rapide : il suffit de monter des lames de calcul 150 dans le bâti 110 de l'armoire 100, en les connectant à des connecteurs préinstallés et déjà reliés à des commutateurs d'interconnexion 140, par exemple des connecteurs QSFP.

[Fig. 2] représente une vue de côté d'une armoire 100 de l'état de la technique précâblée.

La figure 2 montre, selon une vue de côté, une armoire 100 comprenant en façade une pluralité de lames de calcul 150 connectées à une boîte de câblage 180. L'armoire 100 comprend aussi en face arrière une pluralité de lames de calcul 150, ainsi qu'une pluralité de commutateurs d'interconnexion 140. Les éléments en face arrière sont aussi connectés à la boîte de câblage 180. La face avant de l'armoire informatique 100 à la figure 2 est représentée par la flèche A, tandis que la face arrière est représentée par la flèche B.

L'armoire informatique comprend une seule boîte de câblage 180 ne permettant qu'une topologie fixe de réseau d'interconnexion, avec un nombre fixe de connecteurs pour lames de calcul 150 et un nombre fixe de connecteurs pour commutateurs d'interconnexion 140.

La topologie étant choisie et fixe, il n'y a aucun câblage à réaliser. En effet, les connecteurs de la boîte de câblage sont des connecteurs aveugles, permettant de ne pas avoir de connexion à réaliser à la main et ainsi d'avoir des lames de calcul 150 en face avant et en face arrière de l'armoire informatique 100.

Ces systèmes imposent cependant une topologie et un nombre de commutateurs d'interconnexion 140 fixes : il faut que chaque commutateur d'interconnexion 141 prévu soit connecté pour pouvoir distribuer le calcul efficacement selon la topologie choisie. Lorsque l'on veut utiliser moins de commutateurs d'interconnexion 140, il faut alors revoir tout le câblage pour garder la même topologie, et donc le fabricant doit concevoir une nouvelle boîte de câblage 180 accueillant moins de commutateurs d'interconnexion 140 tout en gardant la même topologie. De même, pour utiliser moins de lames de calcul 150, il faut concevoir une nouvelle boîte de câblage 180. Il faut aussi concevoir une nouvelle boîte de câblage 180 pour utiliser une nouvelle topologie. D'un point de vue industriel, cela ne permet aucune flexibilité, ni dans le nombre d'équipements rackables de l'armoire informatique 100, ni dans la topologie de réseau d'interconnexion utilisée.

De plus, les commutateurs d'interconnexion 140 étant coûteux, imposer une topologie fixe et donc un nombre de commutateurs d'interconnexion 140 fixe rend une armoire 100 de l'état de la technique inaccessible à certains potentiels utilisateurs, même si ceux-ci n'auraient pas besoin de toute la capacité de calcul proposée.

Afin de pallier cela, certaines armoires informatiques 100 de l'état de la technique ne sont pas livrées précâblées.

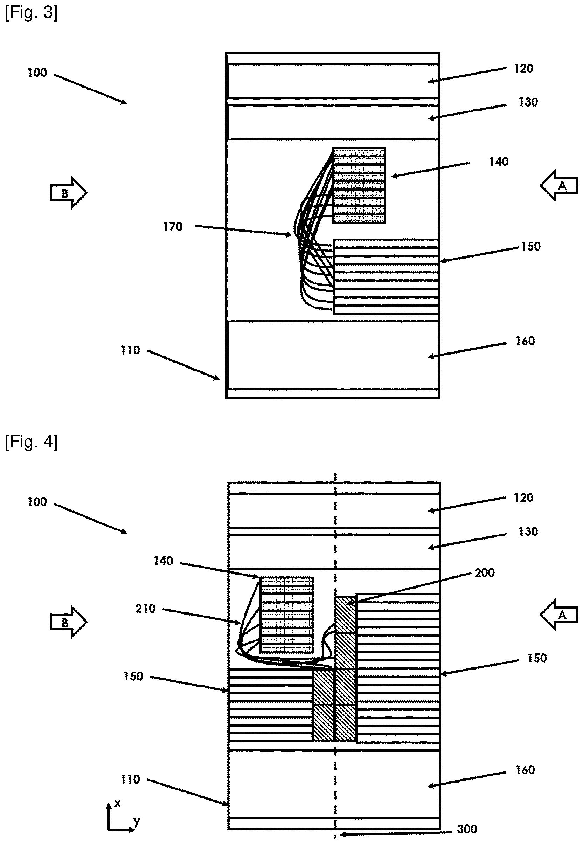

[Fig. 3] représente une vue de côté d'une armoire 100 de l'état de la technique ne comprenant pas de boîte de câblage.

Une armoire 100 de l'état de la technique non précâblée, comprend par exemple en face avant une pluralité de commutateurs d'interconnexion 140 et une pluralité de lames de calcul 150. La face avant de l'armoire informatique 100 à la figure 3 est représentée par la flèche A, tandis que la face arrière est représentée par la flèche B.

Avec une armoire informatique 100 non précâblée, il incombe à un opérateur de câbler l'ensemble des équipements, lames de calcul 150 et commutateurs d'interconnexion 140, afin de créer la topologie voulue. L'opérateur doit alors réaliser un nombre important de connexions entre chaque câble et chaque équipement. Les interconnexions entre équipements sont le plus souvent réalisées par des câbles cuivre ou par des câbles optiques, ayant à chaque extrémité par exemple un connecteur QSFP. Chaque noeud de calcul de chaque lame de calcul 150 comprend un connecteur QSFP permettant d'adresser ce noeud de calcul. Chaque commutateur d'interconnexion 140 comprend une pluralité de connecteurs QSFP.

Un connecteur QSFP faisant 56,5 millimètres de profondeur, et l'ensemble des équipements de l'armoire devant être interconnectés à la main, il est nécessaire d'avoir accès à la face arrière des commutateurs d'interconnexion 140 et des lames de calcul 150 pour les interconnecter. Il n'est donc pas possible d'avoir des lames de calcul 150 en face arrière de l'armoire informatique 100, car il faut pouvoir accéder aux connecteurs en face arrière des lames de calcul 150 et des commutateurs d'interconnexion 140 qui sont situés en face avant de l'armoire informatique 100, comme représenté à la Figure 3.

Cela implique un même encombrement de l'armoire informatique 100 pour un nombre de lames de calcul 150 très inférieur au cas d'une armoire informatique 100 précâblée.

Il existe donc un besoin d'avoir, au sein d'une armoire informatique 100, plusieurs topologies possibles, et un nombre flexible de commutateurs d'interconnexion 140 et de lames de calcul 150, tout en ayant des lames de calcul 150 en face avant et en face arrière de l'armoire informatique 100 et en limitant le nombre de connexions à réaliser à la main pour interconnecter tous les équipements.

Les documents US 2017/0257970 A1 intitulé « RACK HAVING UNIFORM BAYS AND AN OPTICAL INTERCONNECT SYSTEM FOR SHELF-LEVEL, MODULAR DEPLOYMENT OF SLEDS ENCLOSING INFORMATION TECHNOLOGY EQUIPMENT » et US 2018/0295737 A1 intitulé « MODULAR NETWORKING DEVICE CONNECTION SYSTEM » sont connus de l'état de la technique.

### RESUME DE L'INVENTION

L'invention offre une solution aux problèmes évoqués précédemment, en permettant d'avoir, au sein d'une armoire informatique, un nombre flexible d'éléments montables en bâti tels que des lames de calcul et des commutateurs d'interconnexion, en permettant plusieurs topologies possibles, tout en ayant des lames de calcul en face avant et en face arrière de l'armoire informatique et en n'ayant à réaliser à la main que les connexions au niveau des commutateurs d'interconnexion.

Un aspect de l'invention concerne ainsi une armoire informatique modulaire configurée pour accueillir :
- Une pluralité d'éléments montables en bâti, chaque élément montable en bâti s'étendant selon un premier plan et comprenant au moins un premier connecteur connectable en aveugle ;
- Au moins un commutateur d'interconnexion comprenant une pluralité de deuxièmes connecteurs ;
- Les éléments montables en bâti et le commutateur d'interconnexion étant montés sur au moins un bâti de l'armoire informatique, le montage et l'exploitation de ces éléments se faisant par une face avant et/ou par une face arrière de l'armoire, l'armoire informatique modulaire étant caractérisée en ce que :
   - l'armoire informatique modulaire comprend au moins un dispositif d'interconnexion interchangeable configuré pour interconnecter le commutateur d'interconnexion avec les éléments montables en bâti, ledit dispositif d'interconnexion interchangeable comprenant :
   - une paroi de connexion aux éléments montables en bâti, ladite paroi de connexion s'étendant selon un deuxième plan orthogonal au premier plan des éléments montables en bâti, ladite paroi de connexion comprenant une pluralité de troisièmes connecteurs connectables en aveugle, chaque connecteur connectable en aveugle étant configuré pour être connecté en aveugle à au moins le premier connecteur connectable en aveugle d'un des éléments montables en bâti,
   - au moins un câble relié au troisième connecteur de la paroi de connexion, ledit câble d'interconnexion comprenant au moins un quatrième connecteur configuré pour être connecté à au moins un deuxième connecteur de la pluralité de deuxièmes connecteurs compris dans le commutateur d'interconnexion,
   - un boîtier, le boîtier comprenant au moins la paroi de connexion

Grâce à l'invention, il est possible de changer de topologie de réseau d'interconnexion au sein d'une armoire informatique grâce au fait que le dispositif d'interconnexion est interchangeable. De plus, le dispositif d'interconnexion interchangeable comprend une paroi de connexion à un élément montable en bâti, par exemple une lame de calcul, comprenant un connecteur connectable en aveugle. Ce connecteur connectable en aveugle permet de pouvoir monter dans le bâti de l'armoire informatique des éléments en face avant et en face arrière. En effet, le connecteur étant connectable en aveugle, un opérateur n'a pas besoin d'avoir accès à la face arrière des éléments qu'il connecte. Cela limite donc le nombre de connexions qu'un opérateur a à réaliser à la main.

Ce connecteur connectable en aveugle à un élément montable en bâti est relié à un câble, le câble comprenant en outre un connecteur pour la connexion avec un connecteur du commutateur d'interconnexion. Ce câble implique entre autre qu'un opérateur n'a que les connexions des câbles aux commutateurs à réaliser, l'autre connecteur étant compris dans une paroi et étant connectable en aveugle.

Ce câble permet une flexibilité, notamment par le choix du commutateur d'interconnexion auquel il peut être connecté et du connecteur dans le commutateur d'interconnexion, permettant par exemple de modifier en partie la topologie du réseau d'interconnexion. Ce câble peut aussi permettre de pratiquer le « pruning » sur une topologie, par exemple sur une topologie « fat-tree », et de modifier ce pruning. Le pruning est une technique qui consiste à supprimer certains liens et commutateurs d'interconnexion. Il a été montré que cette technique ne dégrade pas significativement la performance du réseau d'interconnexion dans le document « Edgar A. León, lan Karlin, Abhinav Bhatele, Steven H. Langer, Chris Chambreau, Louis H. Howell, Trent D'Hooge, and Matthew L. Leininger. Characterizing parallel scientific applications on commodity clusters: An empirical study of a tapered fat-tree. In Proceedings of the International Conférence for High Performance Computing, Networking, Storage and Analysis, SC '16, pages 78:1-78:12, Piscataway, NJ, USA, 2016. IEEEPress ».

Le pruning permet par exemple d'économiser l'énergie consommée par les éléments du réseau d'interconnexion. Un avantage de l'invention est donc de pouvoir modifier ce pruning facilement.

Outre les caractéristiques qui viennent d'être évoquées dans le paragraphe précédent, l'armoire informatique modulaire selon un aspect de l'invention peut présenter une ou plusieurs caractéristiques complémentaires parmi les suivantes, considérées individuellement ou selon toutes les combinaisons techniquement possibles :
- le dispositif d'interconnexion interchangeable est configuré pour être monté sensiblement selon un plan médian séparant l'armoire informatique modulaire en deux, le plan médian étant parallèle à la face avant de l'armoire informatique modulaire.
- le dispositif d'interconnexion interchangeable comprend au moins un trou configuré pour faire passer le au moins un câble verticalement.
- au moins un élément montable en bâti est une lame de calcul comprenant une pluralité de noeuds et un même nombre de premiers connecteurs que de noeuds de calcul.
- l'armoire informatique modulaire comprend une pluralité de dispositifs d'interconnexion interchangeables.
- l'armoire informatique modulaire comprend une pluralité d'éléments montables en bâti dont au moins un élément montable en bâti monté en face avant de l'armoire informatique modulaire et au moins un élément montable en bâti monté en face arrière de l'armoire informatique modulaire.
- l'armoire informatique modulaire comprend au moins deux dispositifs d'interconnexion interchangeables disposés dos-à-dos.
- le au moins un câble a un débit maximal de 20 Gigabits par seconde.
- le au moins un câble a un débit maximal de 40 Gigabits par seconde.

Un avantage d'avoir le dispositif d'interconnexion interchangeable selon le plan médian de l'armoire, c'est-à-dire au centre de l'armoire, est qu'il permet d'avoir des éléments montable en bâti en face avant et en face arrière de l'armoire informatique modulaire. Le fait qu'il soit monté selon un plan parallèle à la face avant permet un gain de place.

Avantageusement, l'armoire informatique modulaire peut comprendre plusieurs dispositifs d'interconnexion interchangeables, permettant plus de modularité et de flexibilité dans les topologies choisies et une modification du pruning plus aisée. Il est aussi plus simple de monter en charge, c'est-à-dire d'ajouter des éléments montables en bâti, en ajoutant un dispositif d'interconnexion interchangeable supplémentaire. Il est aussi plus aisé de supprimer des éléments montables en bâti, et de simplement enlever un ou plusieurs dispositifs d'interconnexion interchangeables. Cela permet plus de flexibilité dans le nombre d'éléments montables en bâti et de commutateurs d'interconnexion, tout en n'ayant pas à réaliser toutes les connexions pour interconnecter les équipements à la main grâce à la paroi de connexion et aux connecteurs connectables en aveugle.

L'interconnexion des éléments montables en bâti en face avant et en face arrière de l'armoire est avantageusement permise grâce aux connecteurs connectables en aveugle de la paroi de connexion du dispositif d'interconnexion interchangeable et au fait que deux dispositifs d'interconnexion interchangeables soient dos-à-dos.

Lorsque deux dispositifs d'interconnexion interchangeables sont dos-à-dos, il est avantageux que le dispositif d'interconnexion interchangeable soit un boîtier, permettant de ne pas avoir d'interaction entre les câbles des deux dispositifs, et ainsi de pouvoir réaliser la maintenance d'un boîtier sans risquer de débrancher ou d'abîmer un ou plusieurs câbles d'un autre dispositif d'interconnexion interchangeable. Il est aussi avantageux de présenter un trou permettant de faire passer les câbles de manière verticale, notamment si un deuxième dispositif d'interconnexion interchangeable est situé sous un premier dispositif d'interconnexion interchangeable et que les commutateurs d'interconnexion sont situés dans la partie haute de l'armoire informatique modulaire. Cela permet de faire passer les câbles du deuxième dispositif d'interconnexion interchangeable dans le trou du premier dispositif d'interconnexion interchangeable configuré pour cela.

Avantageusement, un même dispositif d'interconnexion interchangeable peut interconnecter plusieurs éléments montables en bâti à un ou plusieurs commutateurs d'interconnexion.

### Avantageusement, le dispositif d'interconnexion interchangeable

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 représente schématiquement une vue de face d'une armoire de l'état de la technique.
- La figure 2 représente une vue de côté d'une armoire de l'état de la technique précablée.
- La figure 3 représente une vue de côté d'une armoire de l'état de la technique ne comprenant pas de boîte de câblage.
- La figure 4 représente une vue de côté d'une armoire informatique modulaire selon un premier mode de réalisation de l'invention.
- La figure 5 représente une armoire informatique modulaire selon un premier mode de réalisation de l'invention.
- La figure 6 représente schématiquement un dispositif d'interconnexion interchangeable connecté à un élément montable en bâti selon un premier mode de réalisation de l'invention.
- La figure 7 représente schématiquement le dispositif d'interconnexion interchangeable connecté à plusieurs élément montable en bâti selon un premier mode de réalisation de l'invention.
- La figure 8 représente schématiquement un dispositif d'interconnexion interchangeable dont le boîtier est en vue en transparence selon un premier mode de réalisation de l'invention.

### DESCRIPTION DETAILLEE

Les figures sont présentées à titre indicatif et nullement limitatif de l'invention.

Sauf précision contraire, un même élément apparaissant sur des figures différentes présente une référence unique.

[Fig. 4] représente une vue de côté d'une armoire informatique modulaire 100 selon un premier mode de réalisation de l'invention.

L'armoire informatique modulaire 100 selon un premier mode de réalisation de l'invention est représentée schématiquement à la figure 4. L'armoire informatique modulaire 100 comprend un bâti 110 une unité d'alimentation PSU 130, une unité de distribution d'alimentation PDU 120, une unité de refroidissement 160, au moins un commutateur d'interconnexion 140, au moins un élément montable en bâti 150 et au moins un dispositif d'interconnexion interchangeable 200.

Par exemple, à la figure 4, l'armoire informatique modulaire 100 comprend une pluralité de commutateurs d'interconnexion 140, une pluralité d'éléments montables en bâti 150 en face avant de l'armoire informatique modulaire 100 et une pluralité d'éléments montables en bâti 150 en face arrière de l'armoire informatique modulaire100. La face avant de l'armoire informatique modulaire 100 est la face visible lorsque l'on regarde l'armoire informatique modulaire 100 selon la flèche A à la figure 4. La face arrière de l'armoire informatique modulaire 100 est la face visible lorsque l'on regarde l'armoire informatique modulaire 100 selon la flèche B à la figure 4.

Les éléments montables en bâti 150 peuvent par exemple être des lames de calcul. Une lame de calcul comprend plusieurs processeurs, par exemple des processeurs de calcul ou des processeurs graphiques, et plusieurs barrettes mémoire, chaque barrette mémoire étant gérée par un processeur, un processeur gérant plusieurs barrettes mémoire. Un ensemble de plusieurs processeurs et de plusieurs barrettes mémoire gérées par ces processeurs est appelé un noeud de calcul. Un élément montable en bâti 150 peut par exemple être une lame de calcul 1U respectant le standard 19 pouces. Un élément montable en bâti 150 est un élément rackable, c'est-à-dire qui se monte sur un rack au sein d'une armoire informatique, soit par la face avant selon la flèche A soit par la face arrière selon la flèche B.

Au moins un élément montable en bâti parmi les éléments montables en bâti 150 peut par exemple être une lame de stockage comprenant au moins un élément de stockage, par exemple un disque dur ou tout autre élément mémoire, ou tout autre élément montable en bâti 150.

Les commutateurs d'interconnexion 140 sont des éléments montables en bâti, comprenant une pluralité de connecteurs. Un commutateur d'interconnexion peut par exemple avoir une hauteur de 1U et une largeur permettant de respecter le standard 19 pouces. Par exemple, un commutateur d'interconnexion 140 peut comprendre 48 connecteurs. Ces connecteurs peuvent être des connecteurs QSFP, QSFP-DD, Ethernet, ou tout autre connecteur réseau.

Les éléments montables en bâti 150 sont interconnectés avec les commutateurs d'interconnexion 140 par des dispositifs d'interconnexion interchangeables 200.

Les dispositifs d'interconnexion interchangeables 200 comprennent des câbles 210.

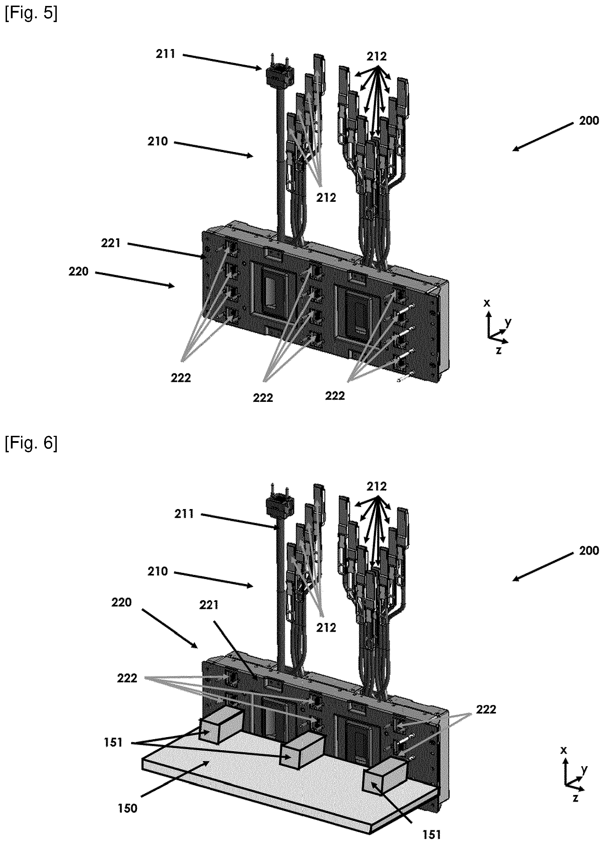

[Fig. 5] La figure 5 représente schématiquement un dispositif d'interconnexion interchangeable 200 selon un premier mode de réalisation de l'invention.

Le dispositif d'interconnexion 200 représenté à la figure 5 comprend, selon un premier mode de réalisation de l'invention, plusieurs câbles 210 ainsi qu'un boîtier 220. Le boîtier 220 comprend une paroi de connexion 221.

La paroi de connexion 221 comprend une pluralité de connecteurs 222. Les connecteurs 222 sont des connecteurs configurés pour être connectables en aveugle, aussi appelés connecteurs fond de panier. On entend par « connectable en aveugle » un connecteur comprenant des moyens d'auto-alignement, c'est-à-dire qu'un connecteur de ce type se guide automatiquement dans la bonne position de couplage. Ainsi, un opérateur réalisant la connexion entre deux connecteurs connectables en aveugle n'a pas besoin d'avoir la vision sur ces deux connecteurs pour réaliser la connexion.

Préférentiellement, les connecteurs 222 sont des connecteurs permettant des transferts de données à haut débit, par exemple à 25 Gigabits par secondes ou à 56 Gigabits par secondes, et à perte d'insertion faible. Les connecteurs 222 connectables en aveugle peuvent par exemple être des connecteurs STRADA Whisper^{®}.

La paroi de connexion 221 s'étend selon le plan formé par les axes vertical x et longitudinal z représentés à la Figure 5.

La paroi de connexion 221 comprend par exemple 12 connecteurs connectables en aveugle 222.

Chaque connecteur connectable en aveugle 222 de la paroi de connexion 221 est configuré pour être connectés en aveugle à un autre connecteur connectable en aveugle, compris dans un élément montable en bâti 150 de l'armoire informatique modulaire 100 selon un premier mode de réalisation de l'invention. Un élément montable en bâti 150 peut comprendre plusieurs connecteurs connectables en aveugle. Les connecteurs 222 de la paroi de connexion 221 sont disposés en rangées. Par exemple, à la Figure 5, les douze connecteurs 222 sont disposés en quatre rangées de trois connecteurs 222. Chacune des quatre rangées est destinée à être connectée à un seul élément montable en bâti 150. Ainsi, les trois connecteurs connectables en aveugle 222 de la première rangée sont destinés à être connectés à trois connecteurs connectables en aveugle d'un même élément montable en bâti 150. Chacun de ces trois connecteurs peut par exemple être utilisé pour adresser un noeud de calcul dans le cas où l'élément montable en bâti 150 est une lame de calcul comprenant trois noeuds de calcul.

Le dispositif d'interconnexion interchangeable 200 selon un premier mode de réalisation de l'invention représenté à la Figure 5 comprend plusieurs câbles 210. Chaque câble 210 est relié à un ou plusieurs connecteurs connectables en aveugle 222 d'un côté du câble pour la connexion avec un élément montable en bâti 150, et à un connecteur 211 ou 212 de l'autre côté du câble pour la connexion respectivement à un commutateur d'interconnexion 140 ou à un commutateur d'administration (non représenté). Chaque câble 210 peut avoir une même longueur fixe, par exemple de deux mètres. Chaque câble 210 peut avoir une longueur différente des autres câbles 210, ou égale à la longueur de seulement un certain nombre d'autres câbles 210.

Par exemple, comme représenté à la Figure 5, le dispositif d'interconnexion interchangeable 200 peut comprendre un même nombre de câbles 210 comprenant un connecteur 212 pour la connexion à un commutateur d'interconnexion 140 que de connecteurs connectables en aveugle 222. Lorsque la paroi de connexion 222 comprend 12 connecteurs connectables à 'aveugle 222 comme représenté à la Figure 5, le dispositif d'interconnexion interchangeable 200 peut comprendre 12 câbles 210 comprenant un connecteur 212 pour la connexion à un commutateur d'interconnexion 140.

Dans une variante au premier mode de réalisation, le dispositif d'interconnexion interchangeable 200 peut ne comprendre que la moitié de câbles 210 comprenant un connecteur 212 pour la connexion à un commutateur d'interconnexion 140 que de connecteurs connectables en aveugle 222. Ainsi, le dispositif d'interconnexion interchangeable 200 peut ne comprendre que six câbles 210 comprenant un connecteur 212 pour la connexion à un commutateur d'interconnexion 140 dans le cas où la paroi de connexion 221 comprend douze connecteurs connectables en aveugle 222.

Le nombre de câbles 210 comprenant un connecteur 212 pour la connexion à un commutateur d'interconnexion 140 pourra être choisi en fonction du nombre de connecteurs disponibles au niveau des commutateurs d'interconnexion 140 et du débit du câble. Par exemple, on pourra utiliser six câbles 210 avec un débit de 40 Gigabits, appelés câbles 40G, par secondes pour interconnecter douze noeuds de calcul répartis sur quatre lames de calcul 150 si ces noeuds de calcul n'utilisent et/ou ne sont capables de gérer qu'un débit de 20 Gigabits par secondes.

On pourra aussi utiliser douze câbles 210 ayant un débit de 20 Gigabits par secondes, appelés câbles 20G, pour interconnecter douze noeuds de calcul répartis sur quatre lames de calcul 150 si ces noeuds de calcul utilisent et/ou sont capables de gérer un débit de 20 Gigabits par secondes.

Pour atteindre de tels débits, les connecteurs 212 de connexion à un connecteur de commutateur d'interconnexion 140 doivent être capables de gérer de tels débits. Typiquement, les connecteurs 212 utilisés peuvent être des connecteurs QSFP+ (selon la dénomination anglo-saxonne « Quad Small Form-factor Pluggable »), permettant un débit de 40 Gigabits par secondes sur quatre canaux 10 Gigabits par secondes InfiniBand^{®} ou sur un seul canal Ethernet 40 Gigabits par secondes. Des connecteurs QSFP28 peuvent aussi être utilisé, permettant 4 canaux 28 Gigabits par secondes, ou un canal à 100 Gigabits par secondes.

Ainsi, le dispositif d'interconnexion interchangeable 200 est dit « interchangeable » car il peut être déconnecté facilement d'un ou plusieurs éléments montables en bâti 150 et remplacé par un autre dispositif d'interconnexion interchangeable 200 comprenant plus ou moins de câbles 210, de débits plus ou moins importants et/ou dont les câbles 210 comprennent des connecteurs différents. Cela permet une flexibilité dans la configuration de l'armoire informatique modulaire 100 et dans le nombre et le type d'éléments montables en bâti 150 et de commutateurs d'interconnexion 150 et d'administration montés dans l'armoire informatique modulaire 100. De plus, dans le cas où un nombre d'éléments montables en bâti 150 doit être retiré de l'armoire informatique modulaire 150, par exemple pour des raisons de coût, un ou plusieurs dispositifs d'interconnexion interchangeables 200 peuvent être eux aussi retirés de l'armoire informatique modulaire 100. Lors d'une montée en charge par exemple, il est possible d'ajouter des éléments montables en bâti 150 au sein de l'armoire informatique modulaire 100 et donc d'ajouter un dispositif d'interconnexion 200 et si nécessaire un commutateur d'interconnexion 140. Cela rend l'armoire informatique modulaire 100 encore plus flexible et apte à accueillir plusieurs types et un nombre différent d'éléments montables en bâti 150 et de commutateurs d'interconnexion 140 durant toute la durée où elle sera exploitée.

En outre, comme représenté à la Figure 5, le dispositif d'interconnexion interchangeable 200 peut comprendre un ou plusieurs câbles 210 comprenant un connecteur 211 pour la connexion à un connecteur d'un commutateur d'administration. Un tel câble 210 est aussi appelé « Sideband link » selon la dénomination anglo-saxonne pour « lien de bande latérale », permettant par exemple d'envoyer des informations de configuration aux noeuds de calcul sur un canal autre que les canaux de transmission d'instructions de calcul.

Un avantage des câbles 210 est qu'ils permettent une flexibilité dans les configurations possibles, par exemple de pouvoir gérer à quel commutateur d'interconnexion 140 est connecté un noeud de calcul d'une lame de calcul 150. Les câbles 210 permettent aussi une flexibilité dans le nombre de commutateurs d'interconnexion 140 et d'éléments montables en bâti 150 utilisés.

Comme représenté à la Figure 4, les dispositifs d'interconnexion interchangeables 200 sont préférentiellement montés dans le bâti de l'armoire informatique modulaire 100 de manière que le plan dans lequel s'étend la paroi de connexion 221 soit parallèle à la face avant selon la flèche A de l'armoire informatique modulaire 100 ou à la face arrière selon la flèche B de l'armoire informatique modulaire 100. C'est-à-dire que les dispositifs d'interconnexion interchangeables 200 sont montés en position verticale. Ainsi, la disposition de la paroi de connexion 221 du dispositif d'interconnexion interchangeable 200 s'étendant selon l'axe x vertical à la Figure 4 est orthogonale à chaque élément montable en bâti 150 s'étendant selon l'axe y, l'axe y étant l'axe longitudinal des éléments montables en bâti 150.

[Fig. 6] La figure 6 représente schématiquement le dispositif d'interconnexion interchangeable 200 connecté à un élément montable en bâti 150 selon un premier mode de réalisation de l'invention.

Le dispositif d'interconnexion interchangeable 200 selon le premier mode de réalisation comprenant la paroi de connexion 221 est connecté à un élément montable en bâti 150, par exemple une lame de calcul. On entend par « Le module d'interconnexion interchangeable 200 est connecté à un élément montable en bâti 150 » le fait qu'au moins un connecteur connectable en aveugle 222 de la paroi de connexion 221 est connecté à au moins un connecteur connectable en aveugle 151 de l'élément montable en bâti 150.

La paroi de connexion 221 s'étend selon un plan orthogonal au premier plan selon lequel s'étend l'élément montable en bâti 150. Par exemple, comme représenté à la figure 6, la paroi de connexion 221 du dispositif d'interconnexion interchangeable 200 s'étend selon le plan formé par les axes vertical x et longitudinal z quand le dispositif d'interconnexion interchangeable 200 est monté dans le bâti de l'armoire informatique modulaire 100 et qu'il est connecté à au moins un élément montable en bâti 150.

L'élément montable en bâti 150 s'étend selon un plan formé par les axes longitudinal z et transversal y quand il est monté dans le bâti de l'armoire informatique modulaire 100. Ainsi, lorsqu'ils sont connectés, le dispositif d'interconnexion interchangeable 200 et en particulier la paroi de connexion 221 s'étend selon un plan orthogonal au plan dans lequel s'étend l'élément montable en bâti 150.

Le connecteur connectable en aveugle 222 compris la paroi de connexion 221 du dispositif d'interconnexion interchangeable 200 est configuré pour être connecté au connecteur connectable en aveugle 151 compris dans l'élément montable en bâti 150. Par exemple, le connecteur connectable en aveugle 151 de l'élément montable en bâti 150 peut être un connecteur femelle et le connecteur connectable en aveugle 222 de la paroi de connexion 221 peut alors être un connecteur mâle. Par exemple, le connecteur connectable en aveugle 151 de l'élément montable en bâti 150 peut être un connecteur mâle et le connecteur connectable en aveugle 222 de la paroi de connexion 221 peut alors être un connecteur femelle. Les deux connecteurs connectables en aveugle 221 et 151 sont des connecteurs connectables en aveugle, par exemple des connecteur STRADA Whisper^{®} ou tout autre type de connecteur connectable en aveugle.

Les connecteurs connectables en aveugle 222 du dispositif d'interconnexion interchangeable 200 peuvent être disposés par exemple, comme représenté à la Figure 5, selon plusieurs rangées, par exemple quatre rangées. Chaque rangée peut par exemple comprendre le même nombre de connecteurs connectables en aveugle 222 que de connecteurs connectables en aveugle 151 compris dans un élément montable en bâti 150. Cela permet avantageusement de pouvoir interconnecter plusieurs éléments montables en bâti 150 à un ou plusieurs commutateurs avec un même dispositif d'interconnexion interchangeable 200.

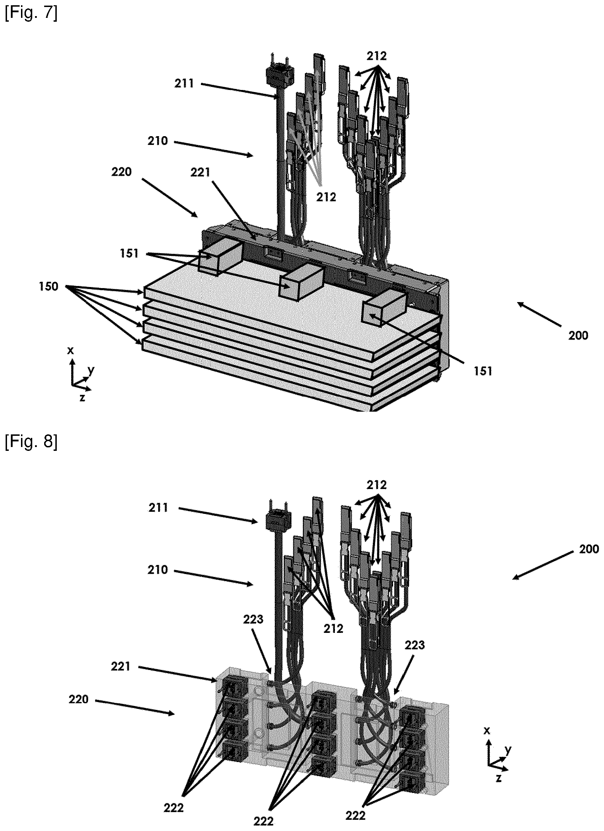

[Fig. 7] La figure 7 représente schématiquement le dispositif d'interconnexion interchangeable 200 connecté à plusieurs élément montable en bâti 150 selon un premier mode de réalisation de l'invention.

Quatre éléments montables en bâti 150 sont connectés à un dispositif d'interconnexion interchangeable 200 à la figure 7. Chacun des éléments montables en bâti 150 est par exemple connecté à la paroi d'interconnexion et donc au dispositif d'interconnexion interchangeable 200 sur une des rangées de connecteurs connectables en aveugle 222 de la paroi de connexion 221. Le dispositif d'interconnexion interchangeable 200 permet alors d'interconnecter une pluralité d'éléments montables en bâti 150 à un ou plusieurs commutateurs d'interconnexion 140 et/ou d'administration.

Comme représenté à la Figure 4, les dispositifs d'interconnexion interchangeables 200 sont préférentiellement montés dans le bâti de l'armoire informatique modulaire 100 de manière que le plan dans lequel s'étend la paroi de connexion 221 soit parallèle à la face avant selon la flèche A de l'armoire informatique modulaire 100 ou à la face arrière selon la flèche B de l'armoire informatique modulaire 100 et de manière à ce que plusieurs éléments montables en bâti 150 puissent être montés en bâti à partir de la face arrière de l'armoire informatique modulaire 100 et à partir de la face avant de l'armoire informatique modulaire 100. Pour cela, préférentiellement, deux dispositifs d'interconnexion interchangeables 200 peuvent être dos-à-dos, c'est-à-dire que l'un des deux dispositifs d'interconnexion interchangeable 200 peut avoir sa paroi de connexion 221 et donc les connecteurs connectables en aveugle 222 de la paroi de connexion 221 tournés vers la face avant et permettant d'interconnecter un ou plusieurs éléments montables en bâti 150 montés par la face avant de l'armoire informatique modulaire 100 avec un ou plusieurs commutateurs d'interconnexion 140 et/ou d'administration tout en ayant l'autre dispositif d'interconnexion interchangeable 200 des deux dispositifs d'interconnexion interchangeable 200 avec sa paroi de connexion 221 et donc les connecteurs connectables en aveugle 222 de la paroi de connexion 221 tournés vers la face arrière et permettant d'interconnecter un ou plusieurs éléments montables en bâti 150 montés par la face arrière de l'armoire informatique modulaire 100 avec un ou plusieurs commutateurs d'interconnexion 140 et/ou d'administration.

Dans la configuration dos-à-dos, il est préférable que les dispositifs d'interconnexion interchangeable 200 soient centrés dans l'armoire informatique modulaire 100 comme représenté à la Figure 4. On entend par « centrés » le fait que le dos de chacun des boîtiers 220 en disposition « dos-à-dos » soit sensiblement dans le plan médian de l'armoire informatique modulaire 100, c'est-à-dire sensiblement dans le plan suivant l'axe médian 300 de la figure 4. Il est alors possible d'avoir des éléments montables en bâti 150 en face avant et en face arrière de l'armoire informatique modulaire 100, car les dispositifs d'interconnexion interchangeables 200 sont au centre de l'armoire informatique modulaire 100.

Ainsi, il est aisé pour un opérateur par exemple d'interconnecter d'un nombre flexible d'éléments montables en bâti 150 avec un nombre flexible de commutateurs d'interconnexion 140 et/ou de commutateurs d'administration. En effet, grâce aux dispositifs d'interconnexion interchangeables 200, un opérateur n'a pas besoin d'avoir accès à l'arrière des éléments montables en bâti 150 pour les interconnecter avec un ou des commutateurs d'interconnexion 140.

Grâce à l'invention, un opérateur a seulement à monter les dispositifs d'interconnexion interchangeables 200 au sein de l'armoire informatique modulaire 100, à monter dans le bâti les éléments montables en bâti, en les glissant dans les « racks » par exemple et en connectant en aveugle les connecteurs connectables en aveugle 151 de chaque élément montable en bâti 150 avec les connecteurs connectables en aveugle 222 de la paroi de connexion 221 et enfin en connectant chacun des connecteurs 211 et 212 des câbles 210 du dispositif d'interconnexion interchangeable à un connecteur d'un ou plusieurs commutateurs d'interconnexion 140 et/ou d'un ou plusieurs commutateurs d'administration selon la topologie voulue et selon le nombre d'éléments montables en bâti 150 souhaités.

L'invention permet donc de ne pas avoir besoin d'avoir accès à l'arrière des éléments montables en bâti 150, d'avoir un nombre d'éléments montables en bâti 150 et de commutateurs flexibles, et de pouvoir choisir une topologie, sans avoir à réaliser toutes les connexions aux éléments montables en bâti à la main.

[Fig. 8] La figure 8 représente schématiquement le dispositif d'interconnexion interchangeable 200 dont le boîtier 220 est en vue en transparence selon un premier mode de réalisation de l'invention.

Le dispositif d'interconnexion interchangeable 200 peut comprendre en outre un ou plusieurs trous 223 pour faire passer les câbles 210, les câbles 210 étant reliés aux connecteurs connectables en aveugle 222 de la paroi de connexion 221. Ces trous peuvent par exemple être des rainures, comme représenté à la Figure 8. Ainsi, selon l'invention, lorsque deux ou plusieurs dispositifs d'interconnexion interchangeables 200 sont l'un au-dessus de l'autre ou des autres selon l'axe vertical x de l'armoire informatique modulaire 100 comme représenté à la figure 4, les câbles du dispositif d'interconnexion interchangeable 200 situé en-dessous selon l'axe vertical x du ou des autres dispositifs d'interconnexion interchangeables 200 peuvent passer dans le trou du ou des dispositifs d'interconnexion interchangeables 200 situés au-dessus de lui pour atteindre le ou les commutateurs d'interconnexion 240 et/ou le ou les commutateurs d'administration.

## Revendications

1. Armoire informatique modulaire (100) configurée pour accueillir :
- Une pluralité d'éléments montables en bâti (150), chaque élément montable en bâti (150) s'étendant selon un premier plan et comprenant au moins un premier connecteur (151) connectable en aveugle ;
- Au moins un commutateur d'interconnexion (140) comprenant une pluralité de deuxièmes connecteurs ;
Les éléments montables en bâti (150) et le commutateur d'interconnexion (140) étant montés sur au moins un bâti (110) de l'armoire informatique (100), le montage et l'exploitation de ces éléments se faisant par une face avant et/ou par une face arrière de l'armoire (100), l'armoire informatique modulaire (100) étant **caractérisée en ce que** :
- l'armoire informatique modulaire (100) comprend au moins un dispositif d'interconnexion interchangeable (200) configuré pour interconnecter le commutateur d'interconnexion (140) avec les éléments montables en bâti (150), ledit dispositif d'interconnexion interchangeable (200) comprenant :
∘ une paroi de connexion (221) aux éléments montables en bâti (150), ladite paroi de connexion (221) s'étendant selon un deuxième plan orthogonal au premier plan des éléments montables en bâti (150), ladite paroi de connexion (221) comprenant une pluralité de troisièmes connecteurs (222) connectables en aveugle, chaque connecteur (222) connectable en aveugle étant configuré pour être connecté en aveugle à au moins le premier connecteur (151) connectable en aveugle d'un des éléments montables en bâti (150),
∘ au moins un câble (210) relié au troisième connecteur (222) de la paroi de connexion (221), ledit câble d'interconnexion (210) comprenant au moins un quatrième connecteur (211, 212) configuré pour être connecté à au moins un deuxième connecteur de la pluralité de deuxièmes connecteurs compris dans le commutateur d'interconnexion (140),
o un boîtier (220), le boîtier (220) comprenant au moins la paroi de connexion (221),

2. Armoire informatique modulaire (100) selon la revendication précédente **caractérisée en ce que** le dispositif d'interconnexion interchangeable (200) est configuré pour être monté sensiblement selon un plan médian séparant l'armoire informatique modulaire (100) en deux, le plan médian étant parallèle à la face avant de l'armoire informatique modulaire (100).

3. Armoire informatique modulaire (100) selon l'une quelconque des revendications précédentes **caractérisée en ce que** le dispositif d'interconnexion interchangeable (200) comprend au moins un trou (223) configuré pour faire passer le au moins un câble (210) verticalement.

4. Armoire informatique modulaire (100) selon l'une quelconque des revendications précédentes **caractérisée en ce qu'**au moins un élément montable en bâti (150) est une lame de calcul comprenant une pluralité de noeuds et un même nombre de premiers connecteurs (151) que de noeuds de calcul.

5. Armoire informatique modulaire (100) selon l'une quelconque des revendications précédentes **caractérisée en ce que** l'armoire informatique modulaire (100) comprend une pluralité de dispositifs d'interconnexion interchangeables (200).

6. Armoire informatique modulaire (100) selon l'une quelconque des revendications précédentes **caractérisée en ce qu'**elle comprend une pluralité d'éléments montables en bâti (150) dont au moins un élément montable en bâti (150) monté en face avant de l'armoire informatique modulaire (100) et au moins un élément montable en bâti (150) monté en face arrière de l'armoire informatique modulaire (100).

7. Armoire informatique modulaire (100) selon l'une quelconque des revendications précédentes **caractérisée en ce qu'**elle comprend au moins deux dispositifs d'interconnexion interchangeables (200) disposés dos-à-dos.

8. Armoire informatique modulaire (100) selon l'une quelconque des revendications précédentes **caractérisée en ce que** le au moins un câble (210) a un débit maximal de 20 Gigabits par seconde.

9. Armoire informatique modulaire (100) selon l'une quelconque des revendications précédentes **caractérisée en ce que** le au moins un câble (210) a un débit maximal de 40 Gigabits par seconde.

## Patentansprüche

1. Modularer IT-Schrank (100), der dazu konfiguriert ist, Folgendes aufzunehmen:
- eine Vielzahl von rackmontierbaren Elementen (150), wobei sich jedes rackmontierbare Element (150) entlang einer ersten Ebene erstreckt und mindestens einen ersten blind verbindbaren Verbinder (151) umfasst;
- mindestens einen Verbindungsschalter (140), der eine Vielzahl von zweiten Verbindern umfasst;
wobei die rackmontierbaren Elemente (150) und der Verbindungsschalter (140) an mindestens einem Rack (110) des IT-Schranks (100) montiert sind, wobei die Montage und der Betrieb dieser Elemente von einer Vorderseite und/oder einer Rückseite des Schranks (100) aus erfolgt, wobei der modulare IT-Schrank (100) **dadurch gekennzeichnet ist, dass:**
- der modulare IT-Schrank (100) mindestens eine austauschbare Verbindungsvorrichtung (200) umfasst, die dazu konfiguriert ist, den Verbindungsschalter (140) mit den rackmontierbaren Elementen (150) zu verbinden, wobei die austauschbare Verbindungsvorrichtung (200) umfasst:
o eine Verbindungswand (221) mit den rackmontierbaren Elementen (150), wobei sich die Verbindungswand (221) entlang einer zweiten Ebene orthogonal zu der ersten Ebene der rackmontierbaren Elemente (150) erstreckt, wobei die Verbindungswand (221) eine Vielzahl von blind verbindbaren dritten Verbindern (222) umfasst, wobei jeder blind verbindbare Verbinder (222) dazu konfiguriert ist, mit mindestens dem blind verbindbaren ersten Verbinder (151) von einem der rackmontierbaren Elemente (150) blind verbunden zu werden,
o mindestens ein Kabel (210), das mit dem dritten Verbinder (222) der Verbindungswand (221) verknüpft ist, wobei das Verbindungskabel (210) mindestens einen vierten Verbinder (211, 212) umfasst, der dazu konfiguriert ist, mit mindestens einem zweiten Verbinder der Vielzahl von zweiten Verbindern, die in dem Verbindungsschalter (140) enthalten sind, verbunden zu werden,
o ein Gehäuse (220), wobei das Gehäuse (220) mindestens die Verbindungswand (221) umfasst,

2. Modularer IT-Schrank (100) nach dem vorstehenden Anspruch, **dadurch gekennzeichnet, dass** die austauschbare Verbindungsvorrichtung (200) dazu konfiguriert ist, im Wesentlichen entlang einer Mittelebene montiert zu werden, die den modularen IT-Schrank (100) zweiteilt, wobei die Mittelebene parallel zu der Vorderseite des modularen IT-Schranks (100) ist.

3. Modularer IT-Schrank (100) nach einem der vorstehenden Ansprüche, **dadurch gekennzeichnet, dass** die austauschbare Verbindungsvorrichtung (200) mindestens ein Loch (223) umfasst, das dazu konfiguriert ist, das mindestens eine Kabel (210) vertikal verlaufen zu lassen.

4. Modularer IT-Schrank (100) nach einem der vorstehenden Ansprüche, **dadurch gekennzeichnet, dass** mindestens ein rackmontierbares Element (150) ein Rechner-Blade ist, der eine Vielzahl von Knoten und genauso viele erste Verbinder (151) wie Rechnerknoten umfasst.

5. Modularer IT-Schrank (100) nach einem der vorstehenden Ansprüche, **dadurch gekennzeichnet, dass** der modulare IT-Schrank (100) eine Vielzahl von austauschbaren Verbindungsvorrichtungen (200) umfasst.

6. Modularer IT-Schrank (100) nach einem der vorstehenden Ansprüche, **dadurch gekennzeichnet, dass** er eine Vielzahl von rackmontierbaren Elementen (150) umfasst, von denen mindestens ein rackmontierbares Element (150) an der Vorderseite des modularen IT-Schranks (100) montiert ist und mindestens ein rackmontierbares Element (150) an der Rückseite des modularen IT-Schranks (100) montiert ist.

7. Modularer IT-Schrank (100) nach einem der vorstehenden Ansprüche, **dadurch gekennzeichnet, dass** er mindestens zwei Rücken an Rücken angeordnete, austauschbare Verbindungsvorrichtungen (200) umfasst.

8. Modularer IT-Schrank (100) nach einem der vorstehenden Ansprüche, **dadurch gekennzeichnet, dass** das mindestens eine Kabel (210) eine maximale Rate von 20 Gigabit pro Sekunde aufweist.

9. Modularer IT-Schrank (100) nach einem der vorstehenden Ansprüche, **dadurch gekennzeichnet, dass** das mindestens eine Kabel (210) eine maximale Rate von 40 Gigabit pro Sekunde aufweist.

## Claims

1. A modular computer cabinet (100) configured to accommodate:
- A plurality of frame-mountable elements (150), each frame-mountable element (150) extending in a first plane and comprising at least one first blind-connectable connector (151);
- At least one interconnection switch (140) comprising a plurality of second connectors;
The frame-mountable elements (150) and the interconnection switch (140) being mounted on at least one frame (110) of the computer cabinet (100), the mounting and the operation of these elements being done by a front face and/or by a rear face of the cabinet (100), the modular computer cabinet (100) being **characterized in that:**
- the modular computer cabinet (100) comprises at least one interchangeable interconnection device (200) configured to interconnect the interconnection switch (140) with the cabinet-mountable elements (150), said interchangeable interconnection device (200) comprising:
∘ a wall (221) for connection to the frame-mountable elements (150), said connection wall (221) extending in a second plane orthogonal to the first plane of the frame-mountable elements (150), said connection wall (221) comprising a plurality of blind-connectable third connectors (222), each blind- connectable connector (222) being configured to be blind- connected to at least the first connector (151) blind- connectable of one of the frame-mountable elements (150),
∘ at least one cable (210) connected to the third connector (222) of the connection wall (221), said interconnection cable (210) comprising at least one fourth connector (211, 212) configured to be connected to at least one second connector of the plurality of second connectors comprised in the interconnection switch (140),
∘ a housing (220), the housing (220) comprising at least the connection wall (221),

2. The modular computer cabinet (100) according to the preceding claim, **characterized in that** the interchangeable interconnection device (200) is configured to be mounted substantially in a median plane separating the modular computer cabinet (100) in two, the median plane being parallel to the front face of the modular computer cabinet (100).

3. The modular computer cabinet (100) according to any one of the preceding claims **characterized in that** the interchangeable interconnection device (200) comprises at least one hole (223) configured to run the at least one cable (210) vertically through.

4. The modular computer cabinet (100) according to any one of the preceding claims, **characterized in that** the at least one frame-mountable element (150) is a compute blade comprising a plurality of nodes and the same number of first connectors (151) as compute nodes.

5. The modular computer cabinet (100) according to any one of the preceding claims **characterized in that** the modular computer cabinet (100) comprises a plurality of interchangeable interconnection devices (200).

6. The modular computer cabinet (100) according to any one of the preceding claims, **characterized in that** it comprises a plurality of frame-mountable elements (150) of which at least one frame-mountable element (150) is mounted on the front face of the modular computer cabinet (100) and at least one frame-mountable element (150) is mounted on the rear face of the modular computer cabinet (100).

7. The modular computer cabinet (100) according to any one of the preceding claims **characterized in that** it comprises at least two interchangeable interconnection devices (200) arranged back-to-back.

8. The modular computer cabinet (100) according to any one of the preceding claims **characterized in that** the at least one cable (210) has a maximum throughput of 20 gigabits per second.

9. The modular computer cabinet (100) according to any one of the preceding claims **characterized in that** the at least one cable (210) has a maximum throughput of 40 gigabits per second.
